# FASCICULE DE BREVET EUROPEEN

(11) **EP 3 808 869 B1**
(45) Date de publication et mention de la délivrance du brevet: **24.07.2024**
(21) Numéro de dépôt: 20202368.5
(22) Date de dépôt: 16.10.2020
(51) Int. Cl.: C23C 14/26, C30B 23/06, C23C 16/44, C23C 14/56, C23C 14/24

(54) **CELLULE D'ÉVAPORATION POUR CHAMBRE D'ÉVAPORATION SOUS VIDE ET PROCÉDÉ D'ÉVAPORATION ASSOCIÉ**
VERDAMPFUNGSZELLE FÜR EINE VAKUUMVERDAMPFUNGSKAMMER, UND ENTSPRECHENDES VERDAMPFUNGSVERFAHREN
EVAPORATION CELL FOR VACUUM EVAPORATION CHAMBER AND ASSOCIATED EVAPORATION METHOD

(30) Priorité: 17.10.2019 FR 1911628
(43) Date de publication de la demande: 21.04.2021
(73) Titulaire: Riber, 95870 Bezons (FR)
(72) Inventeur: GUYAUX, Jean-Louis, 36600 La Vernelle (FR); STEMMELEN, Franck, 95490 VAUREAL (FR); ROUSSEAU, Youri, 78600 Maisons Laffitte (FR)
(74) Mandataire: Jacobacci Coralis Harle

(56) Documents cités:
- EP-A2- 1 505 167
- EP-B1- 1 505 167
- JP-A- 2013 104 117
- JP-A- H03 177 563
- KR-A- 20130 031 446
- US-A1- 2005 034 671
- US-A1- 2010 031 878
- US-A1- 2010 043 710

## Description

### Domaine technique

La présente invention concerne de manière générale le domaine des équipements de dépôt de couche mince de matière sous vide.

Elle concerne plus particulièrement les procédés et les appareils pour déposer de la matière en phase vapeur sur un substrat.

Plus particulièrement, la présente invention s'applique au dépôt en couche mince de matériaux inorganiques ou organiques formés à partir d'halogénure métallique, d'oxyde métallique et/ou de chalcogénure métallique.

### Technique antérieure

On connaît des documents antérieurs US 2007/074654 et US 5104695 des procédés et des appareils destinés au dépôt de matière en phase vapeur sur un substrat. En général, le dépôt de matière est réalisé dans une enceinte sous vide comprenant un moyen de chauffage, une pompe à vide et une cellule d'effusion, aussi appelée cellule d'évaporation, dans laquelle est disposé le matériau source à évaporer. Le matériau source à évaporer est chauffé à une température supérieure à environ 150°C et s'évapore à l'intérieur de la cellule d'effusion. En pratique, la cellule d'effusion possède au moins une ouverture permettant le passage du matériau en phase vapeur vers le substrat. Ainsi au contact du substrat, la matière en phase vapeur se condense pour déposer une couche mince de matière solide. De cette façon, il est possible de déposer une couche de matériau ou de superposer successivement plusieurs épaisseurs de couches minces de matière.

Les cellules d'effusion mises en jeu dans les procédés d'évaporation destinés à déposer un film de matière sur un substrat comprennent plusieurs éléments dont un creuset et un moyen de chauffage. Les moyens de chauffage sont généralement disposés autour du creuset. Le creuset présente en général une extrémité ouverte en haut et un fond fermé en bas dans lequel est déposé le matériau source. L'extrémité ouverte en haut du creuset permet le passage du matériau évaporé en phase vapeur vers le substrat. Bien souvent, un insert possédant une ouverture de taille prédéterminée est disposé sur l'extrémité ouverte en haut du creuset. L'insert a pour fonction principale de contrôler la dispersion du flux de matériau évaporé en sortie de cellule d'effusion. Cet insert permet aussi par exemple de limiter le passage de projections de matières solide et/ou liquide générées lors de l'évaporation du matériau source sur le substrat. Ces projections de matière engendrent des non-uniformités ou des défauts dans le(s) film(s) de matière déposée. L'insert permet aussi d'améliorer la reproductibilité de l'épaisseur d'une couche lors de sa formation sur un substrat.

Cependant, la présence d'une ouverture sur l'insert entraîne une forte perte de chaleur au niveau de l'extrémité en haut du creuset. On observe parfois un phénomène de condensation sur l'insert qui peut entrainer un bouchage (appelé « clogging » en anglais) de l'ouverture de l'insert. Le bouchage de l'ouverture de l'insert rend le flux de dépôt de matière instable lors du procédé de dépôt de matière sur un substrat. Ce phénomène de condensation de matière sur l'insert est d'autant plus accéléré que la température de d'évaporation ou de sublimation du matériau source est faible notamment pour une température inférieure ou égale à 600°C. Ce phénomène dépend de la nature du matériau évaporé.

Les documents JP 2013 104117 A et EP 1505167 décrivent des sources d'évaporation et appareils de dépôt par évaporation sous vide, comportant un dispositif de chauffage s'étendant sur toute la hauteur de la cellule cylindrique et en contact avec le capot.

Dans la fabrication d'écran à base de diodes électroluminescentes organiques (OLED acronyme en anglais), on utilise différents matériaux, notamment des halogénures métalliques, des oxydes métalliques et/ou des chalcogénures métalliques.

Dans le cas de dépôt de fluorure de lithium, par exemple pour la fabrication d'écran de type OLED de grandes dimensions, la température du creuset est modérée, de l'ordre de 800°C à 900°C. La vitesse d'évaporation du fluorure de lithium est très faible, de l'ordre de 1 à 50 g/h. Les procédés de dépôt de fluorure de lithium peuvent être très longs, de plusieurs heures, ou même plusieurs dizaines d'heures. On observe une condensation partielle du matériau fluorure de lithium sur le capot de l'insert. Cette condensation autour de l'ouverture de l'insert modifie la dispersion du flux de matériau gazeux vers le substrat en fonction du temps et peut conduire à un bouchage de l'ouverture de l'insert. Cette condensation de matière autour de l'ouverture de l'insert rend très difficile le maintien d'une vitesse de dépôt constante au cours d'un dépôt ou d'un dépôt sur un substrat à un dépôt sur un autre substrat et nuit à l'homogénéité de la couche déposée. Ce phénomène rend très aléatoire le procédé de fabrication d'écrans de type diode électroluminescente organique (ou OLED pour organic light-emitting diode).

Il est donc nécessaire de développer un dispositif et un procédé d'évaporation permettant d'éviter les problèmes de bouchage de l'ouverture de l'insert, notamment pour les dépôts un dépôt d'halogénure métallique, d'oxyde métallique et/ou de chalcogénure métallique, et tout particulièrement pour un dépôt de fluorure de lithium.

Un des buts de l'invention est de déposer en couche mince un matériau choisi parmi les halogénures métalliques, les oxydes métalliques et/ou les chalcogénures métalliques, dont la tension de vapeur est comprise entre 10⁻³ mbar et 1 mbar, à une température comprise entre 700°C et 1000°C.

### Exposé de l'invention

A cet effet, l'invention propose une cellule d'évaporation pour chambre d'évaporation sous vide, telle que décrite dans la revendication 1, la cellule d'évaporation comprenant un creuset, le creuset étant adapté pour recevoir un matériau solide ou liquide à sublimer ou évaporer, des moyens de chauffage pour chauffer le matériau dans le creuset, une buse disposée à une extrémité ouverte du creuset, la buse comprenant une partie tronconique ayant une ouverture adaptée pour un passage de flux de matériau évaporé ou sublimé vers la chambre d'évaporation sous vide, et un capot disposé sur la buse, le capot ayant une ouverture disposée autour de la partie tronconique de la buse.

Selon l'invention, le capot présente au moins une partie tronconique disposée autour de partie tronconique de la buse, le capot formant une barrière thermique entre le creuset et la chambre d'évaporation sous vide.

Selon un aspect particulier et avantageux, la partie tronconique du capot et la partie tronconique de la buse ayant un même angle au sommet et un même axe, sont disposées à une distance mutuelle comprise entre quelques dixièmes de millimètre et quelques millimètres.

Selon un mode de réalisation, au moins une partie tronconique du capot comporte plusieurs cônes tronqués de même angle au sommet et même axe, lesdits cônes tronqués étant emboités les uns dans les autres autour de la partie tronconique de la buse.

Avantageusement, deux cônes adjacents parmi lesdits cônes tronqués présentent une surface de contact inférieure ou égale à 5% de leur surface respective.

Selon un mode de réalisation, le capot est formé à partir d'une feuille métallique.

Avantageusement, le capot recouvre l'extrémité ouverte du creuset.

Selon l'invention, la buse comporte une paroi cylindrique et deux plaques de fond, la paroi cylindrique reliant les deux plaque de fond à la partie tronconique de la buse, la paroi cylindrique comportant des ouvertures orientées radialement et les deux plaques de fond comprenant chacune au moins une ouverture, lesdites au moins une ouverture des deux plaques de fond étant disposées en chicane.

Selon l'invention, les moyens de chauffage comprennent une première zone de chauffage disposée autour d'une partie basse du creuset et une deuxième zone de chauffage disposée autour de la buse.

Dans un exemple de réalisation, le matériau à sublimer ou évaporer est choisi parmi un halogénure métallique, un oxyde métallique et un chalcogénure métallique.

L'invention concerne aussi un procédé d'évaporation de fluorure de lithium selon la revendication 8.

Bien entendu, les différentes caractéristiques, variantes et formes de réalisation de l'invention peuvent être associées les unes avec les autres selon diverses combinaisons dans la mesure où elles ne sont pas incompatibles ou exclusives les unes des autres.

### Brève description des dessins

De plus, diverses autres caractéristiques de l'invention ressortent de la description annexée effectuée en référence aux dessins qui illustrent des formes, non limitatives, de réalisation de l'invention et où :
[Fig. 1] est une vue éclatée d'une cellule d'évaporation selon un mode de réalisation,
[Fig. 2] est une vue en coupe d'une buse filtrante selon un mode de réalisation particulier,
[Fig. 3] est une vue en coupe d'un capot selon un mode de réalisation,
[Fig. 4]. est une vue schématique en coupe partielle d'une cellule d'évaporation selon un mode de réalisation.

Il est à noter que sur ces figures les éléments structurels et/ou fonctionnels communs aux différentes variantes peuvent présenter les mêmes références.

### Description détaillée

Une cellule d'effusion (ou cellule d'évaporation aussi appelée source d'évaporation dans le présent document) est utilisée comme source de matière pour des dépôts de couches minces dans une enceinte sous vide.

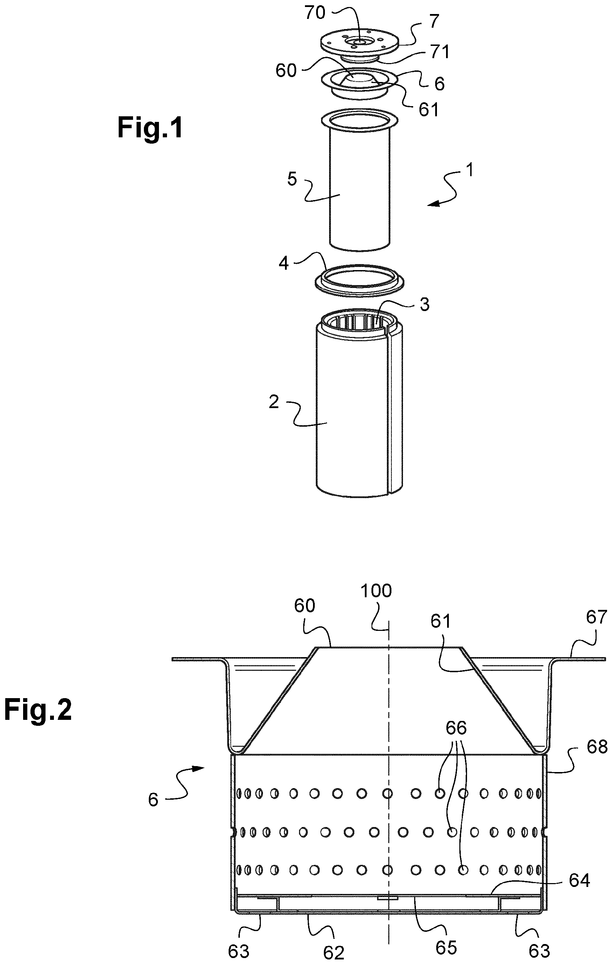

La figure 1 représente schématiquement une vue éclatée d'une source d'évaporation 1 selon un mode de réalisation de la présente divulgation. La source d'évaporation 1 comporte un four 2, le four 2 comprenant au moins un élément chauffant 3, un creuset 5, une buse 6, un capot 7 et éventuellement une rondelle 4.

Le four fournit l'énergie, sous forme de chaleur, nécessaire à l'évaporation du matériau introduit dans le creuset. Le four 2 est généralement de forme cylindrique. Le four 2 peut être fabriqué à partir d'un matériau choisi parmi le tantale, le molybdène, le tungstène, le graphite, le nitrure de bore, l'alumine et/ou l'acier inoxydable. Dans l'exemple illustré, le four 2 est ouvert à son extrémité basse pour le passage de conducteurs électriques et ouvert à son extrémité haute pour l'insertion et l'extraction du creuset 5.

La rondelle 4 est un élément facultatif qui sert à centrer le creuset 5 dans le four 2.

Le creuset 5 est généralement de forme cylindrique. Le creuset 5 comprend une extrémité ouverte et un fond fermé. En fonctionnement, l'extrémité ouverte creuset 5 est orientée vers le haut et le fond disposé en bas de la source d'évaporation 1. Le matériau source, aussi appelé charge, est déposé dans le fond du creuset 5. La charge est généralement déposée dans le creuset 5 sous forme solide ou liquide. Après chauffage, selon le matériau et la température de chauffage, la charge est sublimée ou évaporée en phase vapeur. Généralement, la hauteur initiale de la charge correspond à environ un tiers de la hauteur totale du creuset 5.

Le matériau à évaporer est placé dans le creuset 5. Ensuite, le creuset 5 est inséré dans le four. De façon avantageuse, le creuset 5 est amovible pour permettre le remplissage et/ou le changement de la charge. La charge est par exemple choisie parmi les matériaux ayant une température d'évaporation comprise entre 150°C et 1500°C ou une température de sublimation comprise entre 150°C et 1500°C. Dans le cas du fluorure de lithium, la température de chauffage est comprise entre 800°C et 900°C.

Dans un exemple de réalisation, les moyens de chauffage 3 chauffent le creuset 5 sur toute sa hauteur. Dans l'invention, les moyens de chauffage 3 sont divisés en deux parties : une première zone de chauffage et une deuxième zone de chauffage. La première zone de chauffage est disposée dans la partie basse de la cellule d'évaporation, qui s'étend par exemple du fond jusqu'aux deux tiers de la hauteur de la cellule d'effusion. De façon avantageuse, la deuxième zone de chauffage est disposée dans la partie haute de la cellule d'effusion par exemple dans le tiers supérieur de la cellule d'effusion 1 jusqu'à l'extrémité ouverte du creuset. De tels moyens de chauffage permettent d'ajuster indépendamment la température de chauffage dans le fond du creuset et autour de la buse 6.

Les moyens de chauffage peuvent par exemple comprendre une ou plusieurs résistances de chauffage, aussi appelés filaments ou éléments chauffants. Généralement, les moyens de chauffage sont disposés autour de la partie extérieure du creuset 5. Sur la figure 1, les moyens de chauffage sont disposés à l'intérieur du four 2 et à la périphérie des parois latérales du creuset. La gamme de température de chauffage du creuset est comprise entre 150°C et 1500°C selon le matériau de la charge utilisée.

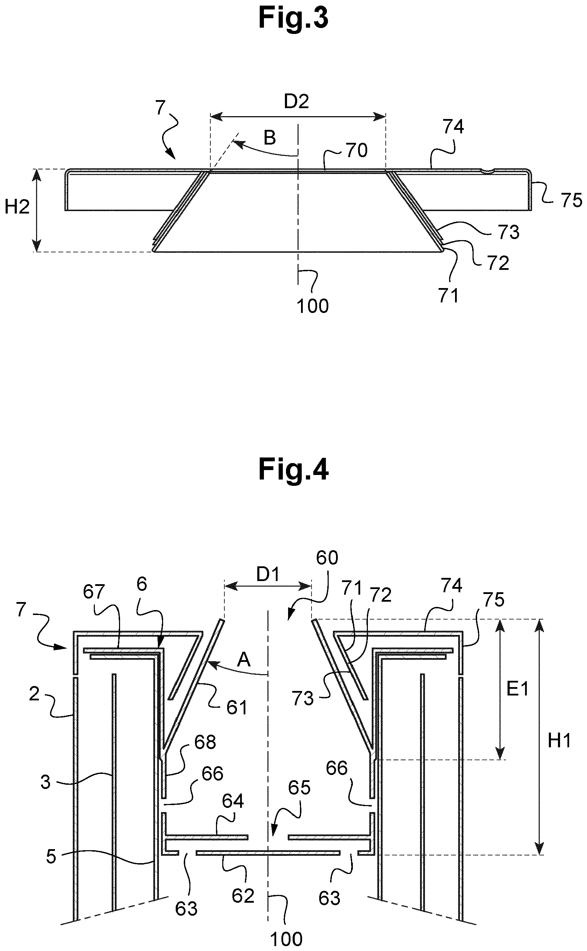

Une buse 6, aussi appelée insert, est disposée sur l'extrémité ouverte du creuset 5, de manière à canaliser le flux de matériau évaporé. De façon avantageuse, la buse 6 comprend une partie tronconique 61, par exemple de section circulaire. La partie tronconique 61 a donc une première extrémité ouverte disposée vers le bas, de diamètre légèrement inférieur au diamètre intérieur du creuset 5 et une deuxième extrémité formant une ouverture 60 disposée vers le haut, de diamètre inférieur au diamètre de la première extrémité. La partie tronconique 61 et l'ouverture 60 permettent de contrôler le flux de matière à déposer sur un substrat dans une chambre d'évaporation. La partie tronconique 61 de la buse 6 est définie par des paramètres géométriques tels qu'un angle d'ouverture A par rapport à l'axe 100 du cône, une hauteur totale H1 et un diamètre D1 de l'ouverture 60. La buse tronconique inversée est disposée sur l'extrémité dans la partie haute du creuset de sorte que les vapeurs du matériau provenant de la charge entrent dans la partie la plus large et sortent par l'embouchure la plus étroite du cône. En général, l'angle d'ouverture A est compris entre 0 degré et 60 degrés, la hauteur E1 est comprise entre 5 mm et 80 mm, et le diamètre D1 d'ouverture est compris entre 2 mm et 100 mm. A titre d'exemple non limitatif, sur la figure 4, l'angle d'ouverture A est de 35 degrés, la hauteur E1 est de 21 mm et le diamètre D1 d'ouverture est de 27 mm. Dans un exemple de réalisation, la buse 6 est fabriquée à partir d'une tôle. Dans un autre exemple de réalisation, la buse 6 est usinée dans un matériau massif. La buse 6 peut par exemple être fabriquée dans un matériau choisi parmi le tantale, le molybdène, le titane, le niobium, le tungstène, le graphite, l'alumine ou le nitrure de bore. La forme conique de la buse 6 permet de contrôler le flux de matière en phase vapeur et ainsi de contrôler l'uniformité du dépôt de matière sur le substrat. La buse 6 est adaptée pour être posée ou fixée sur l'extrémité ouverte du creuset 5.

Selon une variante illustrée sur la figure 2, la buse 6 comprend outre la partie tronconique 61, une grille latérale 68, une première plaque 64, aussi appelée collimateur ou restricteur, et une deuxième plaque 62, aussi appelée impacteur. La première plaque 64 comprend par exemple une ouverture centrale 65 ou de plusieurs ouvertures. La deuxième plaque 62 comprend avantageusement plusieurs ouvertures 63 disposées en périphérie. Les ouvertures 63 de la deuxième plaque 62 sont disposées en chicane par rapport à l'ouverture centrale 65 ou aux ouvertures de la première plaque 64. La taille de la ou des ouvertures de la première plaque 64 est telle que leur surface totale est supérieure ou égale à la surface des ouvertures 63 de l'impacteur 62.

La grille latérale 68 est par exemple formée à partir d'une tôle et éventuellement d'un réseau de perçages 66. En variante, la grille 68 peut être fabriquée à partir d'une tôle, par exemple perforée ou déployée ou à partir d'un grillage, par exemple tissé ou soudé. Le matériau utilisé pour fabriquer la grille 68 est de préférence choisi parmi le tantale (Ta), le nitrure de bore pyrolytique (pBN), le molybdène (Mo), le titane (Ti), le niobium (Nb),le tungstène (W), l'alumine (Al₂0₃) et le graphite.

D'une part, la partie tronconique 61 de la buse 6 est soudée à la grille latérale 68. D'autre part, la première plaque 64 et la deuxième plaque 62 sont aussi soudées à la grille latérale 68. De cette manière, le flux de matériau évaporé provenant du creuset est forcé de passer à travers l'impacteur 62, puis le collimateur 64, ou bien par la grille latérale. L'assemblage de la partie tronconique 61, la grille latérale 68, du collimateur 64, et de l'impacteur 62 forme ainsi une buse filtrante. La buse filtrante est introduite dans l'extrémité ouverte du creuset comme illustré sur la figure 4. La hauteur totale H1 de la buse filtrante est par exemple de 80 mm. La hauteur E1 de la partie tronconique 61 de la buse est par exemple de 21 mm. La buse filtrante réduit la conductance fluidique de l'insert. Toutefois, la buse peut être portée à une température plus élevée pour maintenir la valeur du flux de matériau évaporé.

Dans l'invention, les moyens de chauffage comprennent deux zones de chauffage, la deuxième zone de chauffage s'étend avantageusement autour de la buse filtrante sur la hauteur H1. De cette façon, il est possible de découpler thermiquement d'une part le chauffage de la charge pour former le flux de matériau évaporé et d'autre part le chauffage de la buse pour éviter toute condensation de matériau au niveau de l'ouverture 60.

Selon la présente divulgation, la cellule d'évaporation comporte en outre un capot 7. Le capot 7 comporte une partie support 75 qui vient en appui sur l'embouchure du four 2 de la cellule (voir figure 4). Le capot 7 comporte au moins une partie de forme tronconique 71. De façon particulièrement avantageuse, le capot 7 comporte plusieurs parties tronconiques 71, 72, 73 comme illustré sur la figure 3. Le capot 7 comporte aussi une partie annulaire 74 disposée transversalement à l'axe 100 du cône, qui relie la partie support 75 à la ou les parties tronconiques 71, 72, 73. La partie annulaire 74 du capot contribue à isoler thermiquement la buse 6 vis-à-vis de la chambre d'évaporation. Toutefois, la partie annulaire 74 reçoit un flux de chaleur provenant du four 2 adapté pour maintenir la partie annulaire 74 à une température suffisamment élevée pour ré-évaporer les espèces rétrodiffusées de la chambre d'évaporation vers le capot 7.

De façon avantageuse, la ou les parties tronconiques 71, 72, 73 ont une section circulaire. De façon avantageuse, les parties de forme tronconique 71, 72, 73 ont un même angle au sommet B et un même axe 100. Les parties de forme tronconique 71, 72, 73 sont disposées le long du même axe 100, avec un décalage axial compris entre 0,1 mm et 5 mm de façon à ménager un espace entre deux parties tronconiques adjacentes. De façon particulièrement avantageuse, l'angle au sommet de la partie tronconique 71 est identique à l'angle au sommet A de la partie tronconique 61 de la buse 6. Lorsque la cellule d'évaporation est opérationnelle, la partie tronconique 71 du capot 7 est à une distance comprise entre 0,1 mm et 10 mm de la partie tronconique 61 de la buse 6. Ainsi, la partie tronconique 71 du capot enveloppe une partie de la partie tronconique 61 de la buse 6. La partie tronconique 71 du capot forme un blindage thermique entre la chambre d'évaporation sous vide et la buse 6. De manière encore plus avantageuse, les parties tronconiques 71, 72, 73 forment un blindage thermique encore plus efficace entre la chambre d'évaporation sous vide et la buse 6. En général, le capot 7 est fabriqué en tantale. Dans un exemple de réalisation, chacune des tôles des parties tronconiques 71, 72, 73 est munie d'un dispositif mécanique permettant de maintenir une distance entre parties tronconiques adjacentes tout en garantissant un minimum de contact entre ces parties coniques adjacentes. Le dispositif mécanique peut être constitué de bossages ou de renfoncements formés dans les tôles des parties tronconiques 71, 72, 73. En variante, les parties tronconiques 71, 72, 73 sont maintenues à distance les unes des autres au moyen de rivets. Les parties tronconiques 71, 72, 73 sont par exemple soudées à la partie annulaire 74 autour d'une ouverture 70. Avantageusement, l'ouverture 70 est circulaire et de diamètre D2. La hauteur H2 de la ou des parties tronconiques 71, 72, 73 est inférieure ou égale à la hauteur E1 de la partie tronconique 61 de la buse 6.

Comme illustré sur la figure 4, la partie support 75 du capot 7 vient en appui sur l'embouchure du four 2. La ou des parties tronconiques 71, 72, 73 du capot 7 sont orientées dans le même sens que la partie tronconique 61 de la buse 6, et suivant le même axe 100. L'ouverture 70 du capot est ainsi disposée autour de la partie tronconique 61 de la buse 6. De façon avantageuse, l'ouverture 70 du capot est disposée au maximum à la même hauteur que l'ouverture 60. Pour un résultat optimal, l'ouverture 70 est située juste en dessous, par exemple entre 1 mm et 8 mm, de l'ouverture 60. Le capot 7 et l'insert filtrant 6 sont dimensionnés de manière à ce qu'après assemblage, le capot 7 ne présente pas de contact physique avec l'insert filtrant 6. Plus précisément, la partie support 75 et la partie annulaire 74 du capot 7 sont dimensionnées de manière à laisser une distance minimum, ou distance mutuelle, comprise entre quelques dixièmes de millimètre et quelques millimètres, entre le capot 7 et l'insert filtrant 6. Autrement dit, le capot 7 et l'insert filtrant 6 sont séparés ou isolés mécaniquement l'un par rapport à l'autre.

Le capot 7 constitué de la partie support 75, la partie annulaire 74 et la ou les parties de formes tronconiques 71, 72, 73 forme un blindage thermique entre la partie tronconique 61 de la buse 6 et la chambre d'évaporation sous vide. Un tel capot 7 évite les déperditions de chaleur de la source d'évaporation vers la chambre d'évaporation sous vide et permet de maintenir la partie tronconique 61 à une température élevée. En même temps, le capot 7 est conçu pour favoriser une déperdition contrôlée de chaleur du four 2 vers la partie annulaire 74. En effet, la partie annulaire 74 est orientée face à la chambre d'évaporation sous vide. Cette partie annulaire reçoit un flux de chaleur de manière à maintenir cette partie annulaire 74 à une température suffisamment élevée pour ré-évaporer d'éventuels dépôts de matière par condensation côté chambre d'évaporation.

L'assemblage de la buse 6 et du capot 7 permet d'éviter la condensation des matériaux sur le capot 7 et/ou sur la buse 6 pendant la période d'utilisation de la source. Ce capot 7 permet notamment d'éviter une condensation de matière par rétrodiffusion depuis la chambre d'évaporation sous vide sur le capot 7. De plus, la partie annulaire 74 du capot 7 est maintenue à une température suffisamment élevée pour permettre une ré-évaporation des espèces possiblement rétrodiffusées à la sortie de l'embouchure de la buse 6. Enfin, le capot 7 permet de maintenir la surface interne de la partie tronconique 61 de la buse 6 à une température suffisante pour éviter la condensation de matériaux sur celle-ci.

La source d'évaporation permet de mieux contrôler l'intensité du jet moléculaire généré lors du chauffage du matériau dans le creuset. Une balance à quartz peut être utilisée pour mesurer la vitesse de dépôt dans la chambre d'évaporation. La balance à quartz est positionnée de sorte à ne pas s'interposer entre la source et le substrat destiné à recevoir le dépôt de matière en film mince. La balance à quartz est positionnée de sorte à capter une partie du jet moléculaire et d'en mesurer l'intensité. La balance à quartz fournit un signal, qui peut être utilisé pour ajuster l'intensité du chauffage de la cellule, par l'intermédiaire de la puissance électrique appliquée sur le/les filament(s) afin de maintenir l'intensité du jet moléculaire aussi proche que possible d'une consigne prédéfinie. En phase de production, un tel système de contre-réaction permet de maintenir une épaisseur de film constante, substrat après substrat, dans des limites prédéterminées du procédé.

Dans un premier exemple, on obtient ainsi une vitesse moyenne d'évaporation de l'ordre de 8,05 g/h pendant une durée de 13 h. Dans un deuxième exemple, on obtient une vitesse moyenne d'évaporation de l'ordre de 6,8 g/h pendant une durée de 50 h. Dans ces deux exemples, on n'observe pas de condensation de matériau ni sur le capot 7, ni sur l'impacteur 62, ni sur la paroi interne de la buse 6. Les mesures via une balance à quartz indiquent une très bonne stabilité (fluctuations inférieures à ± 5%) du jet moléculaire tout au long des 50h de dépôt.

La présente divulgation concerne aussi un procédé d'évaporation d'un halogénure métallique, d'un oxyde métallique ou d'un chalcogénure métallique. Un halogénure métallique a une formule chimique de type MBrₓ, MIₓ, MClₓ, MFₓ, où M est un métal et Br, I, CI où F sont respectivement des atomes de brome, chlore, iode et fluor. Un oxyde métallique a une formule chimique de type MOₓ où M est un métal et O l'atome d'oxygène. Un chalcogénure métallique a une formule chimique de type MSeₓ, MSₓ, MTeₓ où M est un métal et où Se, S, Te sont respectivement les atomes de sélénium, soufre et tellure. Ces matériaux présentent généralement, une conductivité thermique faible et sont donc des isolants thermiques.

Ces matériaux sont utilisés dans divers domaines de l'industrie des semiconducteurs. En particulier, en autre, le fluorure de lithium (LiF) est utilisé pour la production d'écrans plats de type OLED. Le fluorure de lithium est transparent en film mince. Le fluorure de lithium est généralement utilisé pour passiver les dispositifs électroniques et/ou pour une fonction optique, par exemple d'extraction de lumière.

Toutefois, le dépôt par évaporation de fluorure de lithium présente des difficultés techniques. Le fluorure de lithium est un matériau dont la pression de vapeur est modérée, typiquement, les températures d'évaporation se situent entre 800 à 900°C. Le fluorure de lithium est un matériau isolant, électriquement et thermiquement. Le fluorure de lithium se vaporise sous la forme moléculaire par évaporation congruente. La vitesse d'évaporation est généralement comprise entre 1 et 50 g/h. La vitesse de dépôt sur un substrat est de l'ordre de vitesse est de 0,1 nm/s à 0,5 nm/s. Or, la durée d'un procédé d'évaporation de fluorure de lithium peut atteindre plusieurs heures ou même plusieurs dizaines d'heures. Dans ces conditions, on constate généralement, dans les procédés de l'art antérieur que du fluorure de lithium se condense sur la buse d'une cellule d'évaporation de l'art antérieur, formant une neige, qui perturbe le maintien d'une vitesse de dépôt constante et avec le temps, pouvant boucher l'ouverture de la buse. La condensation du fluorure de lithium est d'autant plus rapide que l'intensité du jet moléculaire est grande.

A titre d'exemple nullement limitatif, nous décrivons un procédé de dépôt de fluorure de lithium. Le procédé comprend les étapes suivantes : chauffer du fluorure de lithium sous forme solide à une température comprise généralement entre 900°C et 1200°C, supérieure à une température d'évaporation du fluorure de lithium à une pression donnée, comprise généralement entre 0,06 mbar et 6 mbar, de manière à former un flux de fluorure de lithium gazeux; filtrer et diriger le flux de fluorure de lithium gazeux au moyen d'une buse 6 ayant une partie tronconique 61 et une ouverture 60 en direction d'une chambre d'évaporation sous vide, un capot 7 présentant au moins une partie tronconique 71 étant disposé autour de partie tronconique 61 de la buse 6 de manière à isoler thermiquement la buse 6 de la chambre d'évaporation. De façon particulièrement avantageuse, le procédé comporte en outre une étape de chauffage de la buse 6 et du capot 7 à une température suffisante (comprise généralement entre 900°C et 1200°C) pour éviter une condensation de matériaux sur la buse 6 et sur le capot 7.

Le procédé de dépôt permet de déposer du fluorure de lithium, sur un substrat disposé dans la chambre d'évaporation sous vide, avec une vitesse de dépôt comprise entre 0,1 nm/s à 0,5 nm/s, pendant une durée comprise entre 1 minute et 50 heures, pour obtenir une épaisseur de film déposé comprise entre 0,1 nm et 100 nm.

Bien entendu, diverses autres modifications peuvent être apportées à l'invention dans le cadre des revendications annexées.

## Revendications

1. Cellule d'évaporation (1) pour chambre d'évaporation sous vide, la cellule d'évaporation (1) comprenant un creuset (5), le creuset (5) étant adapté pour recevoir un matériau solide ou liquide à sublimer ou évaporer, des moyens de chauffage (3) pour chauffer le matériau dans le creuset, une buse (6) disposée à une extrémité ouverte du creuset (5), la buse (6) comprenant une partie tronconique (61) ayant une ouverture (60) adaptée pour un passage de flux de matériau évaporé ou sublimé vers la chambre d'évaporation sous vide, et un capot (7) disposé sur la buse (6), le capot (7) ayant une ouverture (70) disposée autour de la partie tronconique (61) de la buse (6),
**caractérisé en ce que**
le capot (7) présente au moins une partie tronconique (71, 72, 73) disposée autour de partie tronconique (61) de la buse (6), le capot (7) formant une barrière thermique entre le creuset (5) et la chambre d'évaporation sous vide, la buse (6) comporte une paroi cylindrique (68) et deux plaques de fond (62, 64), la paroi cylindrique (68) reliant les deux plaque de fond (62, 64) à la partie tronconique (61) de la buse (6), la paroi cylindrique (68) comportant des ouvertures (66) orientées radialement et les deux plaques de fond (62, 64) comprenant chacune au moins une ouverture (63, 65), lesdites au moins une ouverture (63, 65) des deux plaques de fond (62, 64) étant disposées en chicane et les moyens de chauffage (3) divisés en deux parties, comprenant une première zone de chauffage disposée autour d'une partie basse du creuset (7) et une deuxième zone de chauffage disposée autour de la buse (6), la première zone de chauffage et la deuxième zone de chauffage étant adaptées pour ajuster indépendamment la température de chauffage dans le fond du creuset et autour de la buse (6).

2. Cellule d'évaporation selon la revendication 1 dans laquelle la partie tronconique (71) du capot et la partie tronconique (61) de la buse ayant un même angle au sommet (A) et un même axe (100), sont disposées à une distance mutuelle comprise entre quelques dixièmes de millimètre et quelques millimètres.

3. Cellule d'évaporation selon la revendication 1 ou 2 dans laquelle ladite au moins une partie tronconique (71, 72, 73) du capot comporte plusieurs cônes tronqués (71, 72, 73) de même angle au sommet (B) et même axe (100), lesdits cônes tronqués (71, 72, 73) étant emboités les uns dans les autres autour de la partie tronconique (61) de la buse (6).

4. Cellule d'évaporation selon la revendication 3 dans laquelle deux cônes adjacents parmi lesdits cônes tronqués (71, 72, 73) présentent une surface de contact inférieure ou égale à 5% de leur surface respective.

5. Cellule d'évaporation selon l'une des revendications 1 à 4 dans laquelle le capot (7) est formé à partir d'une feuille métallique.

6. Cellule d'évaporation selon l'une des revendications 1 à 5 dans laquelle le capot (7) recouvre l'extrémité ouverte du creuset (5).

7. Cellule d'évaporation selon l'une des revendications 1 à 6 dans laquelle le matériau à sublimer ou évaporer est choisi parmi un halogénure métallique, un oxyde métallique et un chalcogénure métallique et dans laquelle la première zone de chauffage est adaptée pour ajuster la température de chauffage dans le fond du creuset entre 900°C et 1200°C et dans laquelle la deuxième zone de chauffage est configurée pour ajuster la température de chauffage de la buse (6) et du capot (7) entre 900°C et 1200°C.

8. Procédé d'évaporation de fluorure de lithium comprenant les étapes suivantes : utiliser une première zone de chauffage disposée autour d'une partie basse d'un creuset (7) pour chauffer du fluorure de lithium dans le creuset (5) à une température supérieure à une température d'évaporation du fluorure de lithium à une pression donnée de manière à former un flux de fluorure de lithium gazeux, filtrer et diriger le flux de fluorure de lithium gazeux au moyen d'une buse (6) en direction d'une chambre d'évaporation sous vide, la buse (6) étant disposée à une embouchure du creuset (5), la buse (6) ayant une partie tronconique (61) et une ouverture (60), la buse (6) comportant une paroi cylindrique (68) et deux plaques de fond (62, 64), la paroi cylindrique (68) reliant les deux plaque de fond (62, 64) à la partie tronconique (61) de la buse (6), la paroi cylindrique (68) comportant des ouvertures (66) orientées radialement et les deux plaques de fond (62, 64) comprenant chacune au moins une ouverture (63, 65), lesdites au moins une ouverture (63, 65) des deux plaques de fond (62, 64) étant disposées en chicane, et isoler thermiquement la buse (6) relativement à la chambre d'évaporation au moyen d'un capot (7) disposé autour de l' ouverture (60) de la buse (6), le capot (7) présentant au moins une partie tronconique (71, 72, 73) disposée autour de partie tronconique (61) de la buse (6), et utiliser une deuxième zone de chauffage disposée autour de la buse (6) pour chauffer la buse (6) à une température adaptée pour éviter la condensation de matériaux sur la buse (6) et sur le capot (7).

## Patentansprüche

1. Verdampfungszelle (1) für eine Vakuumverdampfungskammer, wobei die Verdampfungszelle (1) einen Tiegel (5), wobei der Tiegel (5) dazu ausgelegt ist, ein festes oder flüssiges zu verdunstendes oder zu verdampfendes Material aufzunehmen, Heizmittel (3) zum Erwärmen des Materials im Tiegel, eine an einem offenen Ende des Tiegels (5) angeordnete Düse (6), wobei die Düse (6) einen kegelstumpfförmigen Teil (61) mit einer für einen Durchfluß verdampften oder verdunsteten Materials zur Vakuumverdampfungskammer geeigneten Öffnung (60) aufweist, und eine auf der Düse (6) angeordnete Kappe (7), wobei die Kappe (7) eine um den kegelstumpfförmigen Teil (61) der Düse (6) herum angeordnete Öffnung (70) hat, aufweist,
**dadurch gekennzeichnet, daß**
die Kappe (7) mindestens einen um den kegelstumpfförmigen Teil (61) der Düse (6) herum angeordneten kegelstumpfförmigen Teil (71, 72, 73) aufweist, wobei die Kappe (7) eine thermische Sperre zwischen dem Tiegel (5) und der Vakuumverdampfungskammer bildet, wobei die Düse (6) eine zylindrische Wand (68) und zwei Bodenplatten (62, 64) aufweist, wobei die zylindrische Wand (68) die beiden Bodenplatten (62, 64) mit dem kegelstumpfförmigen Teil (61) der Düse (6) verbindet, wobei die zylindrische Wand (68) radial ausgerichtete Öffnungen (66) aufweist und wobei die beiden Bodenplatten (62, 64) jeweils mindestens eine Öffnung (63, 65) aufweisen, wobei die jeweils mindestens eine Öffnung (63, 65) der beiden Bodenplatten (62, 64) schikanenartig angeordnet sind und wobei die in zwei Teile aufgeteilten Heizmittel (3) eine um einen unteren Teil des Tiegels (5) herum angeordnete erste Heizzone und eine um die Düse (6) herum angeordnete zweite Heizzone aufweisen, wobei die erste Heizzone und die zweite Heizzone dazu ausgelegt sind, die Heiztemperatur am Boden des Tiegels und um die Düse (6) herum unabhängig voneinander anzupassen.

2. Verdampfungszelle gemäß Anspruch 1, bei der der kegelstumpfförmige Teil (71) der Kappe und der kegelstumpfförmige Teil (61) der Düse, die an der Spitze (A) einen gleichen Winkel und eine gleiche Achse (100) aufweisen, in einem gegenseitigen Abstand zwischen einigen Zehntelmillimetern und einigen Millimetern angeordnet sind.

3. Verdampfungszelle gemäß Anspruch 1 oder 2, bei der der mindestens eine kegelstumpfförmige Teil (71, 72, 73) der Kappe mehrere Kegelstümpfe (71, 72, 73) mit dem gleichen Winkel an der Spitze (B) und der gleichen Achse (100) aufweist, wobei die Kegelstümpfe (71, 72, 73) um den kegelstumpfförmigen Teil (61) der Düse (6) herum ineinandergesteckt sind.

4. Verdampfungszelle gemäß Anspruch 3, bei der zwei nebeneinander angeordnete Kegel der Kegelstümpfe (71, 72, 73) eine Kontaktfläche aufweisen, die weniger als oder gleich 5 % ihrer jeweiligen Oberfläche beträgt.

5. Verdampfungszelle gemäß einem der Ansprüche 1 bis 4, bei der die Kappe (7) aus einem Metallblech gefertigt ist.

6. Verdampfungszelle gemäß einem der Ansprüche 1 bis 5, bei der die Kappe (7) das offene Ende des Tiegels (5) bedeckt.

7. Verdampfungszelle gemäß einem der Ansprüche 1 bis 6, bei der das zu verdunstende oder zu verdampfende Material aus einem Metallhalogenid, einem Metalloxid und einem Metallchalcogenid ausgewählt ist und bei der die erste Heizzone dazu ausgelegt ist, die Heiztemperatur am Boden des Tiegels zwischen 900 °C und 1200 °C einzustellen und bei der die zweite Heizzone dazu ausgelegt ist, die Heiztemperatur der Düse (6) und des Tiegels (5) zwischen 900 °C und 1200 °C einzustellen.

8. Verdampfungsverfahren zum Verdampfen von Lithiumfluorid mit den folgenden Schritten: Benutzen einer um einen unteren Teil eines Tiegels (5) herum angeordneten ersten Heizzone, um Lithiumfluorid im Tiegel (5) auf eine Temperatur zu bringen, die höher als eine Verdampfungstemperatur des Lithiumfluorids bei einem gegebenen Druck ist, um einen Fluß von gasförmigem Lithiumfluorid zu bilden, den Fluß des gasförmigen Lithiummfluorids zu filtern und mittels einer Düse (6) in Richtung einer Vakuumverdampfungskammer zu leiten, wobei die Düse (6) an einer Mündung des Tiegels (5) angeordnet ist, wobei die Düse (6) einen kegelstumpfförmigen Teil (61) und eine Öffnung (60) aufweist, wobei die Düse (6) eine zylindrische Wand (68) und zwei Bodenplatten (62, 64) aufweist, wobei die zylindrische Wand (68) die beiden Bodenplatten (62, 64) mit dem kegelstumpfförmigen Teil (61) der Düse (6) verbindet, wobei die zylindrische Wand (68) radial ausgerichtete Öffnungen (66) aufweist und wobei die beiden Bodenplatten (62, 64) jeweils mindestens eine Öffnung (63, 65) aufweisen, wobei die jeweils mindestens eine Öffnung (63, 65) der beiden Bodenplatten (62, 64) schikanenartig angeordnet sind, und die Düse (6) mittels einer um die Öffnung (60) der Düse (6) herum angeordneten Kappe (7) thermisch gegenüber der Verdampfungskammer isolieren, wobei die Kappe (7) mindestens einen um den kegelstumpfförmigen Teil (61) der Düse (6) herum angeordneten kegelstupfförmigen Teil (71, 72, 73) aufweist, und eine um die Düse (6) herum angeordnete zweite Heizzone benutzen, um die Düse (6) auf eine Temperatur zu bringen, die geeignet ist, die Kondensation von Material auf der Düse (6) und der Kappe (7) zu vermeiden.

## Claims

1. An evaporation cell (1) for vacuum evaporation chamber, the evaporation cell (1) comprising a crucible (5), the crucible (5) being adapted to receive a solid or liquid material to be sublimated or evaporated, heating means (3) to heat the material in the crucible, a nozzle (6) placed at an open end of the crucible (5), the nozzle (6) comprising a frustoconical portion (61) having an opening (60) adapted for the passage of a flow of evaporated or sublimated material towards the vacuum evaporation chamber, and a cover (7) placed on the nozzle (6), the cover (7) having an opening (70) arranged about the frustoconical portion (61) of the nozzle (6), **characterized in that**
the cover (7) has at least one frustoconical portion (71, 72, 73) arranged about the frustoconical portion (61) of the nozzle (6), the cover (7) forming a thermal barrier between the crucible (5) and the vacuum evaporation chamber, the nozzle (6) includes a cylindrical wall (68) and two bottom plates (62, 64), the cylindrical wall (68) connecting the two bottom plates (62, 64) to the frustoconical portion (61) of the nozzle (6), the cylindrical wall (68) including openings (66) directed radially and the two bottom plates (62, 64) each comprising at least one opening (63, 65), said at least one opening (63, 65) of the two bottom plates (62, 64) being arranged in zig zag and the heating means (3) divided in two parts comprising a first heating area arranged about a lower portion of the crucible (5) and a second heating area arranged about the nozzle (6), the first heating area and the second heating area being adapted to adjust independently the heating temperature in the bottom of the crucible and about the nozzle (6).

2. The evaporation cell according to claim 1, wherein the frustoconical portion (71) of the cover and the frustoconical portion (61) of the nozzle, having a same apex angle (A) and a same axis (100), are arranged at a mutual distance comprised between a few tenths of millimetres and a few millimetres.

3. The evaporation cell according to claim 1 or 2, wherein said at least one frustoconical portion (71, 72, 73) of the cover includes several frustoconical cones (71, 72, 73) of same apex angle (B) and same axis (100), said frustoconical cones (71, 72, 73) being fitted into each other about the frustoconical portion (61) of the nozzle (6).

4. The evaporation cell according to claim 3, wherein two adjacent cones among said frustoconical cones (71, 72, 73) have a contact surface area smaller than or equal to 5 % of their respective surface area.

5. The evaporation cell according to any one of claims 1 to 4, wherein the cover (7) is formed from a metal sheet.

6. The evaporation cell according to any one of claims 1 to 5, wherein the cover (7) covers the open end of the crucible (5).

7. The evaporation cell according to any one of claims 1 to 6, wherein the material to be sublimated or evaporated is chosen among a metal halide, a metal oxide and a metal chalcogenide and wherein the first heating area is adapted to adjust the heating temperature in the bottom of the crucible between 900°C and 1200°C and wherein the second heating area is configured to adjust the heating temperature of the nozzle (6) and of the cover (7) between 900°C and 1200°C.

8. A method of lithium fluoride evaporation comprising the following steps: using a first heating area arranged about a lower portion of a crucible (5) to heat lithium fluoride in the crucible (5) at a temperature higher than a temperature of evaporation of the lithium fluoride at a given pressure so as to form a flow of gaseous lithium fluoride, filtering and directing the flow of gaseous lithium fluoride by means of a nozzle (6) towards a vacuum evaporation chamber, the nozzle (6) being arranged at a mouth of the crucible (5), the nozzle (6) having a frustoconical portion (61) and an opening (60), the nozzle (6) including a cylindrical wall (68) and two bottom plates (62, 64), the cylindrical wall (68) connecting the two bottom plates (62, 64) to the frustoconical portion (61) of the nozzle (6), the cylindrical wall (68) including openings (66) directed radially and the two bottom plates (62, 64) each comprising at least one opening (63, 65), said at least one opening (63, 65) of the two bottom plates (62, 64) being arranged in zig zag and thermally insulating the nozzle (6) with respect to the evaporation chamber by means of a cover (7) arranged about the opening (60) of the nozzle (6), the cover (7) having at least one frustoconical portion (71, 72, 73) arranged about the frustoconical portion (61) of nozzle (6), and using a second heating area arranged about the nozzle (6) to heat the nozzle (6) at a temperature adapted to avoid condensation of material on the nozzle (6) and on the cover (7).
